Europäisches Patentamt

European Patent Office

Office européen des brevets

(11) Publication number: **0 178 664 B1**

## EUROPEAN PATENT SPECIFICATION

(45) Date of publication of patent specification: **05.08.92**

(51) Int. Cl.5: **H01L 27/14, H01L 27/148**

(21) Application number: **85113198.7**

(22) Date of filing: **17.10.85**

(54) Solid state image sensing device and method for making the same.

(30) Priority: **18.10.84 JP 220016/84**
**29.03.85 JP 63369/85**

(43) Date of publication of application:
**23.04.86 Bulletin 86/17**

(45) Publication of the grant of the patent:
**05.08.92 Bulletin 92/32**

(84) Designated Contracting States:
**DE FR GB**

(56) References cited:
**GB-A- 1 199 934**

**1984 IEEE INTERNATIONAL SOLID-STATE CIRCUITS CONFERENCE, 22nd-24th February 1984, Conf. 31, pages 32,33, IEEE, New York, US; Y. MATSUNAGA et al.: "An interline transfer CCD imager"**

**IDEM**

**PATENTS ABSTRACTS OF JAPAN, vol. 6, no. 221 (P-153)[1099], 5th November 1982; & JP - A - 57 125 332**

**IEEE TRANSACTIONS ON ELECTRON DE-VICES, vol. ED-31, no. 1, January 1984, pages**

**83-88, New York, US; Y. ISHIHARA et al.: "Interline CCD image sensor with an antiblooming structure"**

(73) Proprietor: **Matsushita Electronics Corporation**
**1006, Oaza-Kadoma Kadoma-shi**
**Osaka 571(JP)**

(72) Inventor: **Kuroda, Takao**
**Rekkusu-Manshon B-709 Nakahozumi**
**1-chome**
**Ibaraki City, 567(JP)**
Inventor: **Kuriyama, Toshihiro**
**Koike-Manshon Minami-to 2FB 2-29, Nagaoka**
**2-chome**
**Nagaokakyo City, 617(JP)**
Inventor: **Horii, Kenju**
**17-15, Kitaoji 3-chome**
**Ohtsu City, 520(JP)**
Inventor: **Mizuno, Hiroyuki**
**5-6, Sakuradai 6-chome**
**Nakayama Takarazuka City, 665(JP)**

(74) Representative: **Dr. Elisabeth Jung Dr. Jürgen Schirdewahn Dipl.-Ing. Claus Gernhardt**
**P.O. Box 40 14 68 Clemensstrasse 30**
**W-8000 München 40(DE)**

EP 0 178 664 B1

## Description

The present invention relates to a solid state image sensor device and to a method of fabricating a solid state image sensor device.

In the recent years, improving the characteristics of solid state image sensor devices has been an important aim. Special attention has been directed to solid state image sensor devices of the CCD interline transfer type which show characteristics superior to those of the conventional image pick-up tubes. However, even in such an improved solid state image sensor device, the so-called smear phenomenon which is caused by mixing of a part of electric charges generated by incident light into the transfer means has not been eliminated, and accordingly, the smear phenomenon is an important object to be solved. For improving the smear phenomenon, a p-conductivity type well structure is considered being effective.

A solid state image sensor device having the p-conductivity type well structure is, for instance, disclosed in 1983 IEEE International Solid-State Circuits Conference, FRIDAY FEBRUARY 25. 1983, SESSION XVIII, FAM18.7 p264 - 265. However, in spite of its p-conductivity type well structure, the conventional solid state image sensor device has such shortcomings that the smear phenomenon is not sufficiently eliminated and its sensitivity for long wavelength light is low because its photoelectric conversion regions are undesirably shaped, and furthermore, because the area of the thin p-conductivity type well region which is underneath the photoelectric region is small, the blooming elimination is insufficient.

1984 IEEE International Solid-State Circuits Conference, 22-24 February 1984, Conf. 31, pages 32, 33, IEEE, New York discloses a solid state image sensor device, the dark current of which is to be reduced. In this device a deep N-layer is formed in the semiconductor layer which does not extend below the bottom boundary line of channel stops $P^+$, nor does it extend to the gate electrode either.

The object of the present invention is to provide a solid state image sensor device and a method of fabricating a solid state image sensor device wherein the smear phenomenon is drastically decreased and the blooming phenomenon is sufficiently suppressed. Furthermore, the solid state image sensor device has to show a high sensitivity and have a high integration degree.

This object is solved by a solid state image sensor device having the features of claim 1 and by the method of fabricating a solid state image sensor device as stated in claim 3. Advantageous further examples of the sensor device and of the fabrication method according to the invention are indicated in the subclaims.

The configuration of the photoelectric conversion region allows reducing the electric charges undesirably captured by the vertical CCD-channel, resulting in a drastical reduction of the smear phenomenon. Furthermore, the blooming phenomenum generated by electric charges travelling to the N-region is effectively suppressed.

This invention has various advantages:

(1) The invention provides a solid state image sensor device and a method of its fabrication, the smear phenomenon being drastically decreased.

(2) The invention provides a solid state image sensor device wherein the blooming phenomenon is alleviated.

(3) The invention provides a solid state image sensor device which has a high sensitivity.

(4) The invention provides a solid state image sensor device which is highly integrated.

The invention will be better understood and appreciated, along with other features, from the following detailed description of preferred embodiments of the invention, taken in conjunction with the drawings. In the drawings:

Fig. 1
is a cross sectional view showing a preferred embodiment of a solid state image sensor device in accordance with the present invention,

Fig. 2(a), Fig. 2(b), Fig. 2(c) and Fig. 2(d)
are cross-sectional views showing the flow of fabricating the solid state image sensor device in accordance with the method of the present invention.

In the following the solid state image sensor device and the method of its fabrication are described in connection with preferred embodiments and with reference to the accompanying drawings.

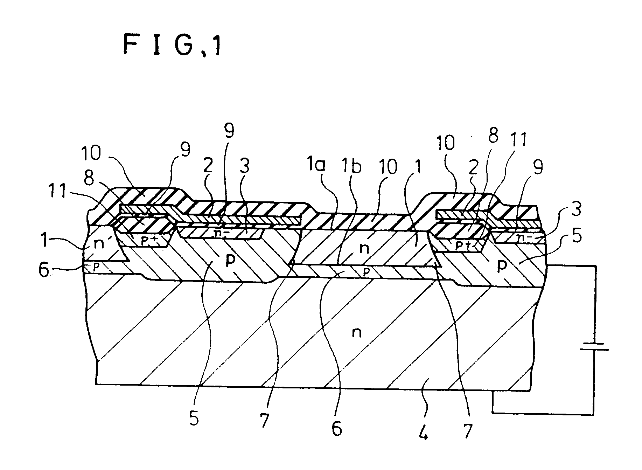

Fig. 1 shows a cross-sectional view showing a preferred embodiment of the solid state image sensor device. Each unit of the device has a semiconductor substrate 4, for instance, of silicon, and formed thereon a p-conductivity type well 5. In the semiconductor substrate 4 a photoelectric conversion region 1 is formed which receives light incident thereon and which issues electrons corresponding to the amount of received light. The p-conductivity type well 5 also has a vertical charge transfer means, for example, a vertical CCD channel region 3, through which the electrons accumulated in the photoelectric conversion region 1 are transferred to an outside circuit by application of a control signal on an insulated gate electrode 2 formed on the vertical CCD channel 3. A reverse bias voltage is impressed across the n-conductivity type substrate 4 and the p-conductivity type well layer which comprises a thick part 5 and thin parts 6, to thereby suppress the blooming phenomenon.

The insulated gate electrode 2 is formed on an insulation film, for instance, a thin SiO₂ film 9, in such a manner that it is insulated from the vertical CCD channel region 3.

As shown in Fig. 1, the photoelectric conversion region 1 is configured in such a manner that it has a larger area in its lower part than in its upper part. That is, the peripheral portions 7, 7 of the photoelectric conversion region 1 are formed bent to the vertical CCD channel 3, i.e. the lower part of the photoelectric conversion region 1 has a concave cross-section. Therefore, the distance between the photoelectric conversion region 1 and the vertical CCD channel 3 is narrower than the corresponding parts in a conventional solid state image sensor device of a p-conductivity type well, and a depletion layer which is on the interface between the p-conductivity type well 5 and the photoelectric conversion region 1 extends towards the vertical CCD channel 3.

As a result of the above-mentioned configuration the electric charges which are to be generated in the p-conductivity type well region 5 due to the oblique irradiation angle of light to the photoelectric conversion region 1 are reduced. Furthermore, the smear electric charges to be generated in the p-conductivity type well 5 by light having an oblique irradiation angle through the photoelectric conversion region 1 decrease, and they are easily captured by the photoelectric conversion region 1. Accordingly, the electric charges which are undesirably captured by the vertical CCD channel 3 are reduced, and therefore the smear phenomenon is drastically reduced.

The configuration of the photoelectric conversion region 1 is such that it has a wider area in the lower part, hence the widest area in the bottom part. Therefore, the thin p-conductivity type area 6 formed in the substrate part 4 and the photoelectric conversion part 1 has a wide area. Therefore, excessive electric charges generated in the photoelectric conversion region 1 are effectively evacuated by punch-through effect between the thin part of the p-conductivity type well 6 and the n-conductivity type substrate 4 and the reversely biased photoelectric conversion region 1. Therefore, the blooming phenomenon, which has hitherto been generated by travelling of the electric charges towards the n-region 3 is effectively suppressed.

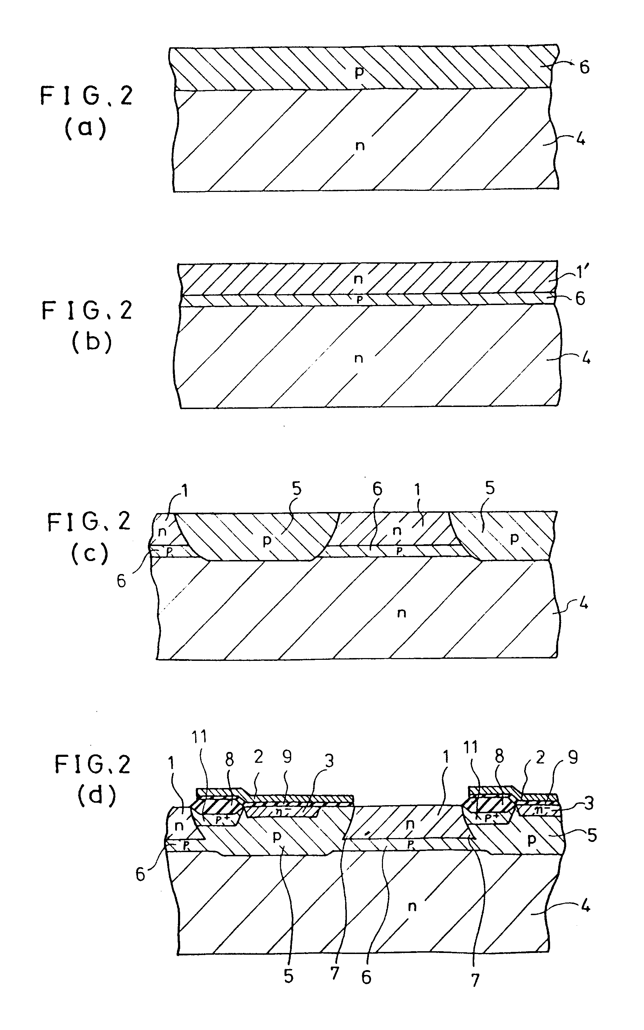

Fig. 2(a), Fig. 2(b), Fig. 2(c) and Fig. 2(d) show a fabrication sequence of one embodiment of the fabricating method in accordance with the present invention. First, as shown in Fig. 2(a), a p-conductivity type impurity doped layer 6 is formed on an n-conductivity type silicon subtrate 4 by means of thermal diffusion followed by a heat treatment or by means of ion-implantation followed by a heat treatment. As the impurity, for instance, B is usable. Next, in a similar manner an n-conductivity type impurity doped layer 1 is formed on the impurity doped layer 6, as is shown in FIG. 2(b). Thereafter, as is shown in FIG. 2(c), a p-conductivity type impurity, for instance, B is selectively diffused from the surface of the n-conductivity type impurity doped layer 1 to such a depth that the underlying p-conductivity type impurity-doped layer 6 is reached, thereby to form p-conductivity type impurity diffused regions 5, 5 ... having a round boundary face, i.e., diffused front.

The selected diffused regions 5, 5 ... are formed using a smaller number of steps in the course of the above mentioned ion-implantation, by appropriately selecting ions with appropriate diffusion coefficients and appropriate temperatures of heat treatment, and by preliminarily ion-implanting materials, for making two or three of the p-conductivity type impurity doped layer 6, the n-conductivity type impurity doped layer 1 and the p-conductivity type impurity doped layer 5, and by subsequently making only one heat treatment.

For instance, by implanting an appropriate amount of p impurity ions, for instance, $1 \times 10^{12} \text{cm}^{-2}$ of B ions and an appropriate amount of n-conductivity type impurity ions, for instance, $0.8 \times 10^{12} \text{cm}^{-2}$ of As, and by subsequently carrying out one heat treatment of these impurity-doped regions, by means of the difference of diffusion coefficients between As ions and B ions, the configuration of FIG. 2(b) is obtainable, wherein the B-diffused layer 6 becomes deeper than the As-diffused layer 1'.

Thereafter, applying known methods, $P^+$-conductivity type channel stopper regions 11, 11 ... are formed by ion-implantation of B, and isolation regions 8, 8 ... made of an oxide film and of vertical CCD charge transfer channels 3, 3 of n-conductivity type made by diffusing As, the thin oxide insulation film 9 covering the p-conductivity type diffused, i.e. impurity-doped regions 5, 5 ... and the oxide insulation film 8 and transfer electrodes 2, 2... of polycrystalline silicon are formed in known steps, as shown in FIG. 2(d). As heat treatments necessary to form these regions, the same heat treatments as to form the p-conductivity type region 6, the n-conductivity type region 1 and the p-conductivity type region 3 can be utilized. If the p-conductivity type impurity layer 6 and the n-conductivity type impurity doped layer 1 are formed by a known epitaxial growth method, the controllability of the thicknesses of these layers becomes satisfactory.

According to the fabricating method of the present invention, the smear phenomena which have been observed in known solid state image sensor devices are significantly decreased, since the photoelectric conversion regions 1, 1 ... are formed so that they have a shape with larger area at the bottom 1b than at surface part 1a.

For a solid state image sensor device of the p-conductivity type well construction, of which type the sensor device according to the invention also is an important object is that the so-called blooming phenomenon is suppressed by evacuating the excessive electric charge from the photoelectric conversion region 1 through the thin p-conductivity type impurity-doped layer 6 under the photoelectric conversion region 1 , by utilizing the layer 6 as a channel to the n-conductivity type substrate 4.

However, since the thin p-conductivity type impurity doped layer 6 becomes the channel for the evacuation of the electric charges, the ability of suppressing the blooming becomes proportional to the area of the thin p-conductivity type doped layer 6. Since the lateral diffusion front of the p-conductivity type impurity doped region 5, 5 ... is accurately controllable, the area of the thin p-conductivity type impurity doped region 6 can also be controlled accurately, and there is no fear of unduly narrowing the area. Thus, suppressing of the blooming ability is assured. Suppressing of the blooming phenomenon is also assured even in case the image sensing device is highly integrated.

Furthermore, according to the fabrication method of the present invention, a solid state image sensor device having a high sensitivity range of wavelength is manufacturable, since the thin p-conductivity type impurity-doped region 6 is disposed in a deep position, seen from the surface of the wafer, and the device has a high sensitivity even for light having a long wavelength.

Furthermore, apart from the above-mentioned embodiment, wherein the peripheral boundary face of the n-conductivity type region expands outwards monotonously with increasing depth, the manner of downwardly expanding the area of the n-conductivity type region is not necessary for the monotonous expanding. Some little waving of the peripheral boundary face is admissible as far as the boundary face is generally oblique to increase the area of the n-conductivity type region 1 with increasing depth.

Apart from the above-mentioned embodiment, in conjunction with the CCD type solid state image sensor device has been described, the present invention is also applicable to a MOS type solid state image sensor device, and furthermore the invention is applicable to a solid state image sensor device of the one-dimensional and of the two-dimensional types.

**Claims**

1. A solid state image sensor device comprising:
   - a semiconductor substrate (4) of a first conductivity type;
   - a semiconductor layer (5, 6) of a second conductivity type opposite to said first conductivity type formed on the semiconductor substrate (4);
   - at least one photoelectric conversion region (1) of said first conductivity type formed in the semiconductor layer (5, 6);
   - at least one insulated gate electrode (2) formed on said semiconductive layer (5); and
   - at least one charge transfer means (3) disposed on one side and away from said photoelectric conversion region (1), whereby electric charges generated from said photoelectric conversion region upon irradiation of light thereto being transferred to said charge transfer means (3) when an electric potential is applied on said insulated gate electrode (2);
   - at least one channel stopper (11) of said second conductivity type formed at the other side with respect to the photoelectric conversion region (1) and contacting the photoelectric conversion region; whereby
   - the photoelectric conversion region (1) has a larger width in its lower part (1b) than in its upper part (1a) and at least a peripheral portion (7) of the lower part has a concave cross-section so that it extends underneath the gate electrode (2).

2. A sensor device in accordance with claim 1, characterised in that the first conductivity type is n-type and the second conductivity type is p-type.

3. Method of fabricating a solid state image sensor device comprising the steps of:
   - forming a first layer (6) of a second conductivity tpye on a semiconductor substrate (4) of a first conductivity type;
   - forming a second layer (1) of the first conductivity type on the first layer (6); and
   - forming an impurity-doped region (5) by selectively diffusing impurities into the second layer (1) of the second conductivity type from the surface thereof, at least to the depth reaching the first layer (6),
   - whereby at least one photoelectric conversion region (1) is surrounded by the first layer (6) and the impurity-doped region (5) of the second conductivity type, and the photoelectric conversion region (1) is formed with such a shape that the width of its upper part (1a) is smaller than that of its lower part (1b) and at least a peripheral portion (7) of the lower part has a concave cross-section;
- forming at least one charge transfer means (3) in the impurity-doped region (5), wherein electric charges generated from the photoelectric conversion region (1) are transferred to the charge transfer means; and
- forming at least one insulated gate electrode (2) above the impurity-doped region (5) between the photoelectric conversion region (1) and the transfer means (3) so that said peripheral portion (7) of the photoelectric conversion region extends underneath the gate electrode.

4. Method in accordance with claim 3, characterised in that the first conductivity type is n-type and the second conductivity type is p-type.

**Revendications**

1. Dispositif de détection d'image à l'état solide comprenant :
   - un substrat semi-conducteur (4) d'un premier type de conductivité ;
   - une couche semi-conductrice (5, 6) d'un second type de conductivité opposé au premier type de conductivité et formée sur le substrat semi-conducteur (4) ;
   - au moins une région de conversion photo-électrique (1) du premier type de conductivité formée dans la couche semi-conductrice (5, 6) ;
   - au moins une électrode de grille isolée (2) formée sur la couche semi-conductrice (5), et
   - au moins un moyen de transfert de charge (3) disposé sur un côté et éloigné de la région de conversion photo-électrique (1), si bien que les charges électriques produites à partir de la région de conversion photo-électrique sur rayonnement de la lumière sur celle-ci sont transférées au moyen de transfert de charge (3) lorsqu'un potentiel électrique est appliqué sur l'électrode de grille isolée (2) ;
   - au moins un arrêt de canal (11) du second type de conductivité formé sur l'autre côté par rapport à la région de conversion photo-électrique (1) et étant en contact avec la région de conversion photo-électrique ; si bien que
   - la région de conversion photo-électrique (1) présente une largeur qui est plus grande dans sa partie inférieure (1b) que dans sa partie supérieure (1a) et au moins une partie périphérique (7) de la partie inférieure présente une section transversale concave de sorte qu'elle s'étend en-dessous de l'électrode de grille (2).

2. Dispositif de détection selon la revendication 1, caractérisé en ce que le premier type de conductivité est du type n et que le second type de conductivité est du type p.

3. Procédé pour fabriquer un dispositif détection d'image à l'état solide comprenant les étapes consistant à :
   - former une première couche (6) d'un second type de conductivité sur un substrat semi-conducteur (4) d'un premier type de conductivité ;
   - former une second couche (1) du premier type de conductivité sur la première couche (6), et
   - former une région dopée d'impuretés (5) en diffusant sélectivement les impuretés dans la seconde couche (1) du second type de conductivité à partir de sa surface, au moins à la profondeur atteignant la première couche (6),
   - si bien qu'au moins une région de conversion photo-électrique (1) est entourée par la première couche (6) et la région dopée d'impuretés (5) du second type de conductivité, et la région de conversion photo-électrique (1) est formée avec une forme telle que la largeur de sa partie supérieure (1a) est inférieure à celle de sa partie inférieure (1b) et qu'au moins une partie périphérique (7) de la partie inférieure présente une section transversale concave ;
   - former au moins un moyen de transfert de charge (3) dans la région dopée d'impuretés (5) dans laquelle les charges électriques produites à partir de la région de conversion photo-électrique (1) sont transférées au moyen de transfert de charge, et
   - former au moins une électrode de grille isolée (2) au-dessus de la région dopée d'impuretés (5) entre la région de conversion photo-électrique (1) et le moyen de transfert (3) de sorte que la partie périphérique (7) de la région de conversion photo-électrique s'étend au-dessous de l'électrode de grille.

4. Procédé selon la revendication 3, caractérisé en ce que le premier type de conductivité est du type n et que le second type de conductivité est du type p.

**Patentansprüche**

1. Festkörperbildsensorvorrichtung, umfassend:
   - ein Halbleitersubstrat (4) eines ersten Leitfähigkeitstyps;
   - eine an dem Halbleitersubstrat (4) gebildete Halbleiterschicht (5,6) eines zweiten Leitfähigkeitstyps, der dem ersten Leitfähigkeitstyp entgegengesetzt ist;
   - wenigstens einen in der Halbleiterschicht (5,6) gebildeten photoelektrischen Umwandlungsbereich (1) des ersten Leitfähigkeitstyps;
   - wenigstens eine an der Halbleiterschicht (5) gebildete isolierte Gate-Elektrode; und
   - wenigstens eine Ladungsübertragungseinrichtung (3), die auf einer Seite und von dem photoelektrischen Umwandlungsbereich (1) im Abstand angeordnet ist, wodurch elektrische Ladungen, die von dem photoelektrischen Umwandlungsbereich bei seiner Bestrahlung mit Licht erzeugt werden, zu der Ladungsübertragungseinrichtung (3) übertragen werden, wenn ein elektrisches Potential an die isolierte Gate-Elektrode (2) angelegt wird;
   - wenigstens eine Kanalsperre (11) des zweiten Leitfähigkeitstyps, die an der anderen Seite mit Bezug auf den photoelektrischen Umwandlungsbereich (1) gebildet ist und den photoelektrischen Umwandlungsbereich kontaktiert; wobei
   - der photoelektrische Umwandlungsbereich (1) in seinem unteren Teil (1b) größere Breite als in seinem oberen Teil (1a) hat und wenigstens ein Umfangsabschnitt (7) des unteren Teils konkaven Querschnitt hat derart, daß er sich unter die Gate-Elektrode (2) erstreckt.

2. Sensorvorrichtung nach Anspruch 1, dadurch gekennzeichnet, daß der erste Leitfähigkeitstyp n-Leitfähigkeit und der zweite Leitfähigkeitstyp p-Leitfähigkeit ist.

3. Verfahren zur Herstellung einer Festkörperbildsensorvorrichtung, umfassend die Schritte des:
   - Bildens einer ersten Schicht (6) eines zweiten Leitfähigkeitstyps an einem Halbleitersubstrat (4) eines ersten Leitfähigkeitstyps;
   - Bildens einer zweiten Schicht (1) des ersten Leitfähigkeitstyps an der ersten Schicht (6); und des
   - Bildens eines störstellendotierten Bereichs (5) durch ausgewähltes Diffundieren von Verunreinigungen in die zweite Schicht (1) des zweiten Leitfähigkeitstyps von deren Oberfläche wenigstens bis zu einer Tiefe, daß die erste Schicht (6) erreicht wird,
   - wobei wenigstens ein photoelektrischer Umwandlungsbereich (1) von der ersten Schicht (6) und dem störstellendotierten Bereich (5) des zweiten Leitfähigkeitstyps umgeben ist und der photoelektrische Umwandlungsbereich (1) mit einer solchen Gestalt gebildet ist, daß die Breite seines oberen Teils (1a) kleiner als diejenige seines unteren Teils (1b) ist und wenigstens ein Umfangsabschnitt (7) des unteren Teils einen konkaven Querschnitt hat; des
   - Bildens wenigstens einer Ladungsübertragungseinrichtung (3) in dem störstellendotierten Bereich (5), wodurch elektrische Ladungen, die von dem photoelektrischen Umwandlungsbereich (1) erzeugt werden, zu der Ladungsübertragungseinrichtung übertragen werden; und des
   - Bildens wenigstens einer isolierten Gate-Elektrode (2) oberhalb des störstellendotierten Bereichs (5) zwischen dem photoelektrischen Umwandlungsbereich (1) und der Übertragungseinrichtung (3) derart, daß der Umfangsabschnitt (7) des photoelektrischen Umwandlungsbereichs sich unter die Gate-Elektrode erstreckt.

4. Verfahren nach Anspruch 3, dadurch gekennzeichnet, daß der erste Leitfähigkeitstyp n-Leitfähigkeit und der zweite Leitfähigkeitstyp p-Leitfähigkeit ist.

F I G ,1

FIG.2
(a)

FIG.2
(b)

FIG.2
(c)

FIG.2
(d)